# EUROPEAN PATENT SPECIFICATION

(11) **EP 0 251 930 B1**
(45) Date of publication and mention of the grant of the patent: **15.09.1993**
(21) Application number: 87401528.2
(22) Date of filing: 01.07.1987
(51) Int. Cl.: H03K 19/177

(54) **Self-timed programmable logic array with pre-charge circuit**
Selbstgetaktetes, programmierbares logisches Feld mit Vorladungsschaltung
Circuit logique programmable auto-synchronisé avec circuit de précharge

(30) Priority: 02.07.1986 US 881079
(43) Date of publication of application: 07.01.1988
(73) Proprietor: DIGITAL EQUIPMENT CORPORATION, Maynard, MA 01754 (US)
(72) Inventor: Rose, Robert C., Hudson Massachusetts 01749 (US); Patel, Jash, Northboro Massachusetts 01532 (US)
(74) Representative: Mongrédien, André

(56) References cited:
- EP-A- 0 174 397
- EP-A- 0 178 437
- EP-A- 0 231 550
- GB-A- 2 138 189
- US-A- 3 959 782
- IEEE JOURNAL OF SOLID-STATE CIRCUITS, vol. SC-16, no. 2, April 1981, pages 103-107, New York, US; C.M. LIN: "A 4 mum NMOS nand structure PLA"
- IEEE Transactions on Computers, Vol. C-28 (1979), Sept. No. 9, pages 602 to 608

## Description

### BACKGROUND OF THE INVENTION

### 1. Field of the Invention

The invention relates generally to the field of programmable logic arrays, and more specifically to self-timed programmable logic arrays having precharge circuitry for precharging minterm and output lines prior to the decoding of the input signals and encoding of the output signals.

### 2. Description of the Prior Art

Since digital integrated circuits have been fabricated using large and very large scale integration ("LSI" and "VLSI") circuit techniques, programmable logic arrays have become popular mechanisms for implementing control logic circuits, such as state sequencers and state decoders, as well as a number of circuits previously implemented using combinational logic. A programmable logic array receives a plurality of input signals, and in response to the pattern of asserted and negated input signals, generates a plurality of output signals having a selected pattern of asserted and negated signals. The encoding of the input signals, that is, the particular input signals which are asserted and negated, determines the encoding of the output signals.

A programmable logic array is divided into two sections, or "planes", one functioning as a decoder and the other functioning as an encoder. The two sections are connected by a plurality of conductors, which are termed "minterm" conductors. The decoder section receives the input signals, and, based on their encoding, enables one or several of the minterm conductors. The enabled minterm conductors, in turn, cause the encoder to assert or negate the output signals in a selected pattern.

The circuits comprising the decoder plane operate to perform an AND function to enable each of the minterm conductors. Each AND circuit receives the true or complements of the selected input signals. In response to a predetermined encoding, only particular minterm conductors are selected, that is, they have a different condition (high or low voltage level) than do the rest.

The circuits comprising the encoder plane effectively operate to perform an OR function, with each output line being driven by one circuit performing the OR function. The input signals to each OR circuit are the signals on the minterm conductors from the decoder section. When a minterm conductor is selected, the OR circuits connected to that minterm conductor establish the conditions of the output lines.

A primary benefit of using a programmable logic array is that the array typically can have a very regular physical shape on the integrated circuit chip. The input lines to the circuits performing the AND function, which include the true and/or complement of the input signals, and the output bit lines from the OR circuits in an physical implementation of a typical VLSI programmable logic array are all largely disposed in parallel. In addition, the minterm conductors are largely disposed orthogonally to the input and output lines. Each AND circuit is implemented using a plurality of transistors, with one transistor being used for each input signal, or its complement, which controls the minterm conductor. Each transistor is connected between the associated minterm conductor and ground and controlled by the signal on an input (or complement) line.

To speed operation of the programmable logic arrays, the minterm conductors and the output bit lines are commonly precharged, that is, they are placed in a selected electrical condition, typically a high voltage condition prior to enabling the AND and OR circuits to operate, which allows the signals to be generated more quickly. In the past, to prevent the input signals from affecting the precharge operation, gates have been placed on the input lines and the minterm conductors between the decoder and encoder sections to disable transmission of the input signals onto the input lines and transmission of the signals over the minterm conductors from the decoder section to the encoder section. However, the addition of the gates effectively disturbs the regular layout of the lines in the programmable logic array. In addition, the additional gates adds delays in the signal paths, which slows the operation of the programmable logic array.

Many prior art documents are discussed hereunder.

EP-A-0 174 397 describes a multi-level logic circuit which includes a first plurality of logic circuits that are connected in a cascade arrangement. A second plurality of dummy logic circuits also connected in cascade arrangement are used to generate logic pulses for evaluating the first plurality of logic circuits. A clock source provides a precharged signal to the first plurality of logic circuits and the second plurality of dummy logic circuits and an evaluation circuit is used to combine the clock signal with an output signal from the dummy logic signal to obtain an evaluation signal for evaluating the logic states of the first plurality of logic circuits.

GB-A-2 138 189 describes a programmed logic array with auxiliary pull-up means to increase precharging speed. In such a programmed logic array having a crosspoint AND plane and a crosspoint OR plane, each of these planes has input lines and output lines intersecting at crosspoints across each of which a transistor driver is connected or not, depending upon the details of the desired logic transformation function of the plane. Each output line is connected to a separate clocked pull-up (or precharge) transistor for precharging that line, and the source terminal of each driver is connected to a clocked pull-down transistor for logic evaluation or computation. In order to reduce the time needed for precharging, the source terminal of every driver is connected to another clocked pull-up transistor.

EP-A-0 178 437 describes a dynamic CMOS programmable logic array , in which a clock delay circuit in parallel with the sub-circuits belonging to the AND-level, generates the clock signal for the sub-circuits belonging to the OR-level. The clock delay circuit conforms to the sub-circuits belonging to the AND-level and is driven by clock signals for that level.

US-A-3 959 782 describes an MOS divice, usually connected to a power supply through an MOS device, which is connected so that load current can be supplied to the MOS circuit when it is turned on and leakage current can be supplied thereto when it is turned off. It has been found that the recovery time of such an arrangement upon turn off is substantially longer than the turn on time.

An article entitled "A High Density Programmable Logic Array Chip", Roy A. Wood (IEEE transactions on computer, volume C-28, 1979, number 9) describes a programmable logic array (PLA) chip design using special array folding techniques and an on-chip bus structure has been developed. It overcomes the sparseness in conventional large PLA configurations. The design is a masterslice FET chip personalized for one particular application during processing. Software algorithms are used to map conventional PLA formats into the new structure. The techniques used provide improved logic function and performance for an FET array technology.

### SUMMARY OF THE INVENTION

The invention provides a new and improved programmable logic array which has an improved circuit for initially precharging the minterm conductors and output bit lines and an internal timing circuit for indicating when the output signals are valid and can be used. The timing circuit also facilitates timing within the programmable logic array so that the encoder section is operative after the signal on the appropriate minterm conductor is asserted and valid at the encoder section.

In brief summary, the new programmable logic array includes an input decoder section and an output encoder section, which are interconnected by a plurality of minterm conductors, and an internal timing circuit. Each minterm conductor is controlled by an AND circuit comprising a plurality of transistors each controlled, in turn, by an input signal or its complement. Each minterm conductor also controls a plurality of OR circuits in the encoder section, with each OR circuit also comprising a plurality of transistors each controlling, in turn, an output bit line. Each OR circuit comprises a plurality of transistors each controlling one output bit line. The programmable logic array also includes a circuit for precharging the minterm conductors and the output bit lines. During the precharge operation, transistor switches maintain the transistors comprising the AND and OR circuits in the decoder and encoder sections in a disabled condition to allow precharge to be accomplished quickly.

The internal timing circuit includes two sections, one timing the decoder section and the other timing the encoder section. The two sections are connected by a timing conductor. An enabling signal is received which turns on the transistor switch controlling the decoder section, which switch also controls the decoder timing section. A predetermined time later, the decoder timing section generates an enabling signal which turns on the transistor switch which controls the encoder section, which switch also controls the encoder timing section. The encoder timing section generates an output enabling signal a predetermined time later to enable downstream circuitry to use the output signals from the programmable logic array.

The delay between the receipt of the enabling signal and the generation of the transmitted enabling signal by each timing section is related to the time required for the corresponding decoder and encoder section to generate the signals on the minterm and output conductors and transmit them to the succeeding section or the downstream circuitry. The delay in each timing section is governed by a resistance-capacitance circuit with the capacitance provided by a plurality of parallel-connected transistors, the number of transistors corresponding to the maximum number of transistors connected to a minterm conductor or output bit line in the associated decoder or encoder circuit.

The invention is directed to a programmable logic array comprising an input decoder section and an output encoder section connected by a plurality of minterm conductors, said input decoder section selecting a minterm conductor in response to the encoding of a plurality of input signals, and the output encoder section transmitting a plurality of output signals each on a respective output conductor and having an encoding determined by the selected minterm conductor,
A. said input decoder section including a plurality of decoder stages each connected to a node to which one of said minterm conductors is connected, at least some of said decoder stages including at least one control transistor connected to said respective node for controlling the selection of said minterm conductors under control of an input signal, and a decoder switch means connected to conduct current from a decoder switch node in response to a decoder enabling signal, said control transistors in all of said decoder stages being connected to said decoder switch node so that current flows through said control transistors and said decoder switch means in response to said decoder enabling signal;
B. said output encoder section including a plurality of encoder stages each connected to a node to which one of said output conductors is connected, at least some of said stages including at least one control transistor connected to said respective node for controlling the transmission of an output signal on said output conductor in response to the selection of said minted conductor, and an encoder switch means connected to conduct current from an encoder switch node in response to an encoder enabling signal, said control transistors in said encoder stages being connected to said encoder switch node so that current flows through said control transistors and said encoder switch means in response to said encoder enabling signal; and
C. precharge means responsive to a precharge signal for precharging the respective nodes;
D. said programmable logic array further characterized by
   i) a self-timing circuit including a precharge conductor having a timing node,
      a resistance-providing transistor, and timing means,
   ii) wherein said resistance-providing transistor connects said decoder switch means to said precharge conductor, said precharge conductor connects said resistance-providing transistor to said encoder switch means to supply said encoder enabling signal to said encoder switch means,
      and said precharge conductor is connected to said precharge means to precharge said timing node to a selected voltage when said respective nodes are precharged,
   iii) said resistance-providing transistor is biased to have an effective resistance slightly larger than the effective resistance of any one of the control transistors, and
   iv) wherein said timing means is coupled with said precharge conductor and said decoder switch node and is controlled by said decoder switch means for reducing the voltage on said precharged timing node at a predetermined rate determinative of the time after said decoder switch means receives said decoder enabling signal at which the encoder enabling signal is provided to said output encoder section, whereby said decoder switch means controls said self-timing circuit and said decoder section.

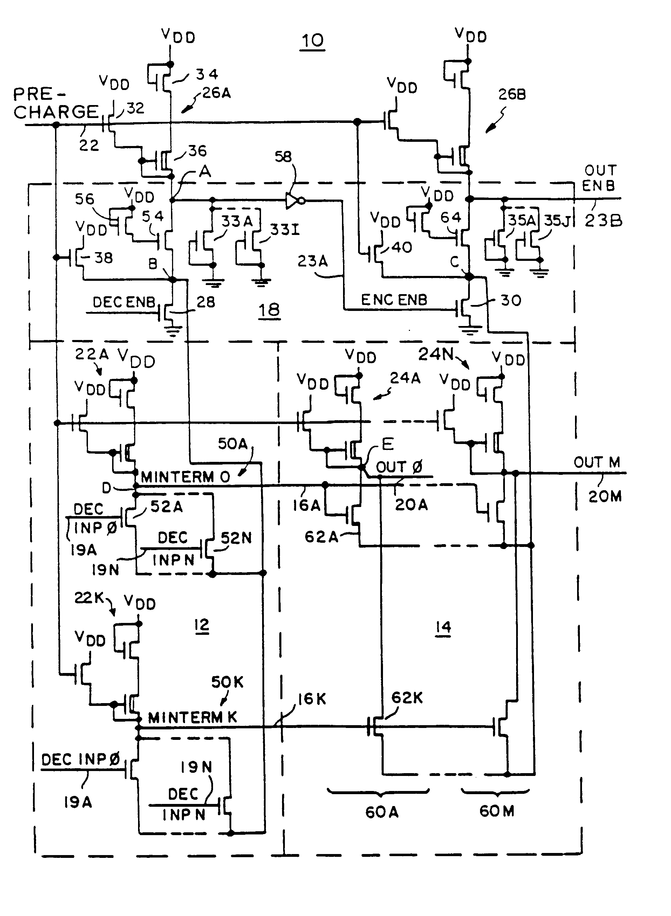

### BRIEF DESCRIPTION OF THE DRAWING

This invention is pointed out with particularity in the appended claims. The above and further advantages of this invention may be better understood by referring to the following description taken in conjunction with the accompanying drawing, which depicts a circuit diagram of a programmable logic array constructed in accordance with the invention.

### DETAILED DESCRIPTION OF AN ILLUSTRATIVE EMBODIMENT

With reference to the drawing, a programmable logic array 10 constructed in accordance with the invention includes a decoder section 12 connected to an encoder section 14 through a plurality of minterm conductors 16A through 16K. The decoder section operates in response to DEC INP 0 through DEC INP N decode input signals that are received on input lines 19A through 19N. Each decode input signal DEC INP 0 through DEC INP N represents the true or complement of one of the input signals INP 0 through X (not shown) that are coupled to the programmable logic array by upstream circuitry (also not shown), to enable the generation of output signals OUT 0 through OUT M in response thereto.

The decoder section 12, in response to a particular encoding of the decode input signals DEC INP 0 through DEC INP N, selects the appropriate minterm conductors 16A through 16K. That is, one or several of the minterm conductors 16A through 16K are selected in response to the pattern of assertions of the DEC INP 0 through DEC INP N decode input signals, which represents a corresponding pattern of assertions and negations of the associated INP 0 through X input signals from the upstream circuitry. As is often the case in a programmable logic array, a minterm conductor may be selected regardless of the condition of one or more of the input signals; those signals are termed "don't care" signals. The selection of a minterm conductor enables the encoder section to generate a plurality of output signals OUT 0 through OUT M on output bit lines 20A through 20M, with the output signals having a selected encoding of asserted and negated signals. The OUT 0 through OUT M output signals may be used for controlling downstream circuitry (not shown).

The programmable logic array 10 also includes a self-timing circuit 18 which performs several functions. First, the self-timing circuit 18 disables both the decoder section 12 and the encoder section 14 during a precharge phase that is initiated by a PRECHARGE signal on a line 22. During the precharge phase, the minterm conductors 16A through 16K and output conductors 20A through 20M are charged to a high voltage level for the succeeding phases. Following the precharge phase, in response to a DEC ENB decode enable signal, the self-timing circuit enables the decoder section 12 to select appropriate minterm conductors 16A through 16K in response to the DEC INP 0 through N decode input signals. During this time the self-timing circuit 18 maintains the encoder section 14 in a disabled condition.

After the minterm conductors have been selected and the appropriate signals have been transmitted to the encoder section 14 and allowed to settle, the self-timing circuit 18 generates an ENC ENB encode enable signal on a line 23A which enables the encoder section 14 to energize selected output bit lines 20A through 20M, as determined by the minterm conductor that is selected, to generate a pattern of the OUT 0 through OUT M output signals. Finally, the self-timing circuit 18 generates an OUT ENB output enable signal on a line 23B which is transmitted to circuitry (not shown) which is to use the OUT 0 through OUT M output signals to indicated that those output signals are then valid and can be used.

Each of the minterm conductors 16A through 16K and each of the output bit lines 20A through 20M is precharged through an associated precharge buffer circuit 22A through 22K, for the minterm conductors, and 24A through 24M, for the output bit lines. Precharge buffer circuits 26A and 26B are also provided to precharge lines 23A and 23B in the self-timing circuit 18. The precharge buffer circuits are actuated in response to a PRECHARGE precharge enabling signal to precharge the lines 23 and the input to the inverter 58 in the self-timing circuit 18. Since each of the precharge buffer circuits is identical, only precharge buffer circuit 26A will be described in detail.

Preliminarily, during the precharge phase, the DEC ENB decode enable signal and the ENC ENB encode enable signal are both negated, which turns off transistors 28 and 30. Transistors 28 and 30 are operable during the decode and encode phases to enable the decode section 12 and encode section 14, respectively, as described below. Since the PRECHARGE signal is initially negated prior to the precharge phase, a transistor 32 in precharge buffer circuit 26A is turned off. When the PRECHARGE signal is asserted, the transistor 32 is turned on, allowing current to flow from the power supply V_{dd} to the node A in the self-timing circuit 18. The charging of node A serves to charge the drain capacitances associated with a plurality of transistors 33A through 33I that are connected to node A. The node A is thus charged to a voltage level approximately that of the power supply, less the threshold drop of the transistor 32. Similarly, the charging performed by precharge buffer circuit 26B also serves to charge the gate capacitances associated with a plurality of transistors 35A through 35J. The number of transistors 33A through 33I and 35A through 35J is selected as described below.

At the end of the precharge phase, the PRECHARGE signal is negated, thereby switching off the transistor 32. The precharge buffer circuit 26A includes a direct unswitched path between node A and the power supply through a load transistor 34 and a depletion mode transistor 36. Transistor 36 provides a weak static pull-up for node A to prevent leakage from node A from degrading the voltage level of node A after the precharge phase has been completed and prior to the commencement of the succeeding phases of operation of the programmable logic array. Load transistor 34 operates essentially as a load resistor, and also provides a threshold voltage drop between its gate and source terminals. The voltage drop ensures that the the voltage level of node A at most reaches the voltage level of the power supply V_{dd} less the voltage drop between the gate and source terminals of transistor 34. This improves the speed of operation of the circuit during the succeeding phases of operation, as the pull-down devices (for example, transistor 28, as described below) only have to pull down from the lower voltage level, not from the power supply voltage V_{dd}. As explained below, however, when transistor 28 is turned on during the phase after precharge, transistors 34 and 36 are unable to maintain the node A at a high voltage level.

Self-timing circuit 18 also includes transistors 38 and 40 which are connected between the power supply V_{dd} and the drain terminals of transistors 28 and 30 et nodes B and C, respectively. During the precharge phase, the gates of transistors 38 and 40 are energized by the PRECHARGE signal to enable the transistors to precharge the nodes B and C, respectively.

The decoder section 12 includes a plurality of stages 50A through 50K, each of which is connected to and, during the decode section evaluation phase, controls one of the minterm conductors 16A through 16K. Each stage is similar, and so only stage 50A will be described in detail. Stage 50A includes a plurality of transistors 52A through 52N connected in parallel between a node D, to which the precharge buffer circuit 22A end minterm conductor 16A are also connected, and node B in the self-timing circuit 18. Each of the transistors 52A through 52N is controlled by one of the DEC INP 0 through N decode input signals. As is conventional, the transistors in stages 50A through 50K may not receive all of the DEC INP 0 through N signals; the selection of the DEC INP 0 through N signals which are received in any one stage will be made clear below.

Prior to the decode phase, the ones of the DEC INP 0 through DEC INP N signals which control the stage are applied to the transistors 52A through 52N. If any of the applied DEC INP 0 through signals is high, the associated transistor 52A through 52N are in the enabled condition, but, since transistor 28 is then off, the node B is in a high voltage condition, and so none of the transistors is actually turned on, or conducting. When the transistor 28 is turned on in response to the DEC ENB signal during the decode phase, the transistors 52A through 52N that are enabled by the respective DEC INP signal are turned on.

If any of the transistors 52A through 52N are turned on during the decode phase, the node D is discharged to ground through the transistor 28, pulling the minterm conductor 16A to a low voltage level. The stage 50A thus operates to perform a NOR function in response to the DEC INP 0 through N signals that are coupled to it, pulling the MINTERM 0 line 16A to a low voltage condition if any of the DEC INP 0 through DEC INP N decode input signals that are coupled to the stage are high. As is described in C. Mead and L. Conway, Introduction to VLSI Systems, (Addison-Wesley, 1980) pp. 79-82, by the appropriate selection of the association between the true and complement of the INP 0 through X signals and the DEC INP 0 through N signals that are coupled to the stage, the stage 50A operates to perform an AND function on a particular encoding of certain of the INP 0 through X signals. The remaining stages 50B through 50K operate similarly.

When the DEC ENB decode enable signal turns on transistor 28, node A in the self-timing circuit 18 also begins to discharge through a transistor 54. Transistor 54 is biased on by the power supply V_{dd} through a load transistor 56 and effectively operates as a resistor whose resistance depends on the biasing voltage provided by transistor 56. The charge stored in the capacitances of transistors 33A through 33I discharges through the transistor 54 and the enabled transistor 28, and the voltage level at node A falls, at a rate and with a characteristic related to the multiplicative product of the resistance of transistor 54 (assuming that the resistance of transistor 54 is much greater than the effective resistance of transistor 28) and the effective drain capacitance of transistors 33A through 33I (which is the sum of the drain capacitances of the individual transistors). The voltage level of node A decreases, and as it does, an inverter 58 causes the voltage level of the ENC ENB signal on line 23A to increase. When the voltage level of the ENC ENB encode enable signal reaches a threshold level, at that point transistor 30 begins to turn on.

With reference again to the MINTERM 0 through K signals on lines 16A through 16K, it will be appreciated that the rates at which the voltage levels of those signals fall are largely governed by the capacitances and resistances of the transistors 52A through 52N in stages 50A through 50K in the decoder section 12. Assuming that all of the transistors 52 have substantially the same structure and electrical characteristics, the stage whose MINTERM signal will be the slowest to fall during a decode phase will be the one with the largest number of transistors 52, and that will occur when only one of the transistors 52 in the stage is turned on by a DEC INP signal. In that case, the sole transistor 52 which is turned on discharges all of the electrical charge that was stored in the capacitances of the other transistors during the precharge phase at a rate determined by the effective resistance of the one transistor that is on, and the sum of the capacitances of the other transistors.

As mentioned above, the rate at which the voltage level of node A decreases, and the comcomitant rate at which the voltage level of the ENC ENB encode enable signal increases, is determined by the combined capacitance of the transistors 33A through 33I and the resistance of transistor 54. The number of transistors 33A through 33I is selected to be the same as the maximum number of transistors 52 in one of the stages 50 in decode section 12, and their physical and electrical characteristics are related to the corresponding characteristics of transistors 52, so that the capacitance at node A due to transistors 33 is directly related to the capacitance of the transistors 52 in the stage whose MINTERM signal takes the longest to drop. In addition, the transistor 54 in self-timing circuit 18 is biased to have an effective resistance somewhat larger than the resistance of any one of the transistors 52. Accordingly, the rise time for the ENC ENB encode enable signal on line 22, that is, the time required for the ENC ENB signal to effectively turn transistor 30 on in self-timing circuit 18, is related to the longest time that would be required for all of the MINTERM signals to fall that are going to fall during the decode phase, and for that MINTERM signal to propagate to the encoder section 14. By the appropriate selection of the resistance of transistor 54 and the drain-to-gate capacitances of transistors 33A through 33I, the rise time for the ENC ENB encode enable signal is slightly greater than the longest time required for all of the MINTERM signals to propagate to encoder section 14.

The encoder section 14 is also constructed of a plurality of stages 60A through 60M each of which controls one of the output bit lines 20A through 20M. The stages are all similar, and only a representative stage 60A, which controls output bit line 20A will be described in detail. Stage 60A includes a plurality of transistors 62A through 62K. All of the drain terminals of transistors 62 are connected to output bit line 20A to form a node E, and all of their source terminals are connected to node C and controlled by transistor 30. The gates of all of the transistors are controlled by a minterm line 16A through 16K, so that the on and off conditions of the respective transistors 62A through 62K are controlled by the respective one of the MINTERM signals. Depending on the required encoding of the OUT 0 output signal in response to the MINTERM 0 through K signals, some of transistors 62A through 62K may not be present; if the OUT 0 signal is high in response to the assertion of a MINTERM signal, a transistor 62A through 62K is not provided for the corresponding minterm line.

Stage 60A operates in a manner similar to the operation of stage 50A described above. During both the precharge phase and the decode phase, transistor 30 in self-timing circuit 18 is off and node C is thus floating above a ground voltage level. Regardless of the condition of the transistors 62 in response to the associated MINTERM signals, after the precharge phase, node E and the OUT 0 output signal will be at a high voltage level. Immediately after the decode phase, and before the encode phase, the sole MINTERM 0 through K signals which are at a high voltage level enables the transistors 62A through 62K which are provided. When the ENC ENB encode enable signal turns transistor 30 on, the enabled transistors 62A through 62K are turned on and the voltage level of node E and the OUT 0 output signal, which had been high due to the precharge, will begin to fall. If no transistor 62 is present at that minterm line, the voltage level of the node E, and thus of the OUT 0 signal will be unchanged.

It will be appreciated that, by the appropriate selection of the connection of transistors 62A through 62K in each of stages 60A through 60M, the stages 60A through 60M operate to perform an OR operation in controlling the OUT 0 through M output signals. A transistor 62 is connected between nodes E and C for any MINTERM signal which, when asserted, is to drive the OUT 0 signal to a low voltage condition, and no transistor 62 is provided if the OUT 0 signal is to remain in a high voltage condition.

When the ENC ENB encode enable signal turns transistor 30 on, the charge that had been stored in the drain-to-gate capacitances of transistors 35A through 35J also begins to discharge through transistors 64 and 30. The rate at which this occurs determines the rate at which an OUT ENB output enable signal falls. As described above in connection with transistors 33A through 33I and 54 and the ENC ENB encode enable signal on line 23A, by the appropriate selection of the number of transistors 35A through 35J, and their drain capacitances, and the effective drain-to-source resistance of transistor 64, the fall time of the OUT ENB signal on line 23B can be made to correspond to the fall times for the OUT 0 through M signals on lines 20A through 20M. Downstream circuitry (not shown) may use the OUT ENB output enable signal to determine when the OUT 0 through M signals are valid and can be used.

It will be appreciated by those skilled in the art that the programmable logic array depicted in the drawing and described above avoids the problems of the prior art which required gates in the minterm lines to enable their precharge, thereby allowing for a more simplified and regular layout of the programmable logic array on an integrated circuit chip. During the precharge phase, the transistors 28 and 30 allow the nodes B and C to effectively float, allowing the precharge to occur without having to gate the INP 0 through INP N signals and the MINTERM A through K signals, which effectively reduces the number of transistors required in the programmable logic array.

The self-timing feature also reduces the amount of external control circuitry required, as it enables the decode, encode, end output phases to be effectively initiated in response to the one DEC ENB decode enable signal which controls transistor 28. Furthermore, by the self-timing feature, the timings of the ENC ENB encode enable and OUT ENB output enable signals are closely related to the generation and validity of the related MINTERM 0 through K and OUT 0 through M signals, respectively.

## Claims

1. A programmable logic array (10) comprising an input decoder section (12) and an output encoder section (14) connected by a plurality of minterm conductors (16A-16K), said input decoder section selecting a minterm conductor in response to the encoding of a plurality of input signals, and the output encoder section transmitting a plurality of output signals each on a respective output conductor (20A-20M) and having an encoding determined by the selected minterm conductor,
A. said input decoder section (12) including a plurality of decoder stages (50A-50K) each connected to a node (D) to which one of said minterm conductors is connected, at least some of said decoder stages including at least one control transistor (52A-52N) connected to said respective node for controlling the selection of said minterm conductors under control of an input signal, and a decoder switch means (28) connected to conduct current from a decoder switch node (B) in response to a decoder enabling signal, said control transistors in all of said decoder stages being connected to said decoder switch node so that current flows through said control transistors and said decoder switch means in response to said decoder enabling signal;
B. said output encoder section (14) including a plurality of encoder stages (60A-60M) each connected to a node (E) to which one of said output conductors is connected, at least some of said stages including at least one control transistor (62A-62K) connected to said respective node for controlling the transmission of an output signal on said output conductor in response to the selection of said minterm conductor, and an encoder switch means (30) connected to conduct current from an encoder switch node (C) in response to an encoder enabling signal, said control transistors in said encoder stages being connected to said encoder switch node so that current flows through said control transistors and said encoder switch means in response to said encoder enabling signal; and
C. precharge means (26A, 26B) responsive to a precharge signal for precharging the respective nodes (D, B, C, E);
D. said programmable logic array further characterized by
i) a self-timing circuit (18) including a precharge conductor (23A) having a timing node (A), a resistance-providing transistor (54), and timing means (54, 33A-33I),
ii) wherein said resistance-providing transistor (54) connects said decoder switch means (28) to said precharge conductor (23A), said precharge conductor connects said resistance-providing transistor (54) to said encoder switch means (30) to supply said encoder enabling signal to said encoder switch means (30), and said precharge conductor (23A) is connected to said precharge means (26A, 26B) to precharge said timing node (A) to a selected voltage when said respective nodes are precharged,
iii) said resistance-providing transistor (54) is biased to have an effective resistance slightly larger than the effective resistance of any one of the control transistors (52), and
iv) wherein said timing means (54, 33A-33I) is coupled with said precharge conductor and said decoder switch node (B) and is controlled by said decoder switch means (28) for reducing the voltage on said precharged timing node (A) at a predetermined rate determinative of the time after said decoder switch means (28) receives said decoder enabling signal at which the encoder enabling signal is provided to said output encoder section (14), whereby said decoder switch means (28) controls said self-timing circuit (18) and said decoder section (12).

2. A programmable logic array as defined in claim 1, wherein said self-timing circuit (18) further includes an inverter (58) coupled between said timing node (A) and said encoder switch means (30) for causing the voltage level of the encoder enabling signal to increase as the voltage on said timing node decreases, and said encoder switch means (30) comprises a transistor having a control terminal for enabling the flow of current through said encoder switch means (30) and said control transistors (62A-62K) in response to said encoder enabling signal exceeding a selected threshold level.

3. A programmable logic array as defined in claim 2, further characterized by said timing means (54, 33A-33I) further including:
A) a resistance-capacitance circuit (33A-33I) connected to said timing node (A), said resistance-capacitance circuit having a capacitance value selected in relation to the maximum capacitance value of the control transistors (62A-62K) in any of said decoder stages, and including said resistance-providing transistor (54); and
B) wherein said precharge means precharges said timing node (A) and said resistance-capacitance circuit (33A-33I) prior to assertion of said decoder enabling signal, and during assertion of said decoder enabling signal said resistance-capacitance circuit discharges through said resistance-providing transistor to provide an asserted encoder enabling signal when said resistance-capacitance circuit has discharged to a selected level.

4. A programmable logic array as defined in claim 3, wherein said resistance-capacitance circuit (33A-33I) includes a plurality of capacitance-providing transistors, the number of said capacitance-providing transistors corresponding to the maximum number of control transistor (52A-52N) controlling the selection of a minterm conductor.

5. A programmable logic array as defined in claim 1, further characterized by an encoder timing means (35A-35J, 64) connected to said encoder switch means (30) for generating an output enabling signal at a selected time after the assertion of said encoder enabling signal.

6. A programmable logic array as defined in claim 5, further characterized by
A) said encoder timing means (35A-35J, 64) including an encoder resistance-capacitance circuit (35A-35J) connected to an encoder timing node, said encoder resistance-capacitance circuit having a capacitance value selected in relation to the maximum capacitance value of the control transistors (62A-62K) in any of said encoder stages, and encoder resistor means (64) connected to said encoder timing node and said encoder switch node (C); and
B) said precharge means precharging said encoder timing node and said encoder resistance-capacitance circuit (35A-35J, 64) prior to assertion of said encoder enabling signal, and during assertion of said encoder enabling signal said encoder resistance-capacitance circuit discharging through said encoder resistor means (64) to provide an asserted output enabling signal when said encoder resistance-capacitance circuit has discharged to a selected level.

## Patentansprüche

1. Programmierbares Logik-Array (10) mit einem Eingangsdekodiererabschnitt (12) und einem Ausgangskodiererabschnitt (14), die über eine Vielzahl von Zwischenleitungen (engl.: minterm conductors) (16A-16K) miteinander verbunden sind, wobei der Eingangsdekodiererabschnitt als Antwort auf die Kodierung einer Vielzahl von Eingangssignalen eine Zwischenleitung auswählt und der Ausgangskodiererabschnitt eine Vielzahl von eine von der ausgewählten Zwischenleitung festgelegte Kodierung aufweisenden Ausgangssignalen jeweils auf einer jeweiligen Ausgangsleitung (20A-20M) sendet, und
A. der Eingangsdekodiererabschnitt (12) eine Vielzahl von Dekodiererstufen (50A-50K) enthält, die jeweils mit einem Knoten (D) verbunden sind, an den eine der Zwischenleitungen angeschlossen ist, wobei mindestens einige der Dekodiererstufen mindestens einen Steuertransistor (52A-52N) enthalten, der mit dem jeweiligen Knoten verbunden ist, um die Auswahl der Zwischenleitungen unter Steuerung eines Eingangssignales zu steuern, und eine Dekodiererschalteinrichtung (28), die angeschlossen ist, um als Antwort auf ein Dekodiererfreigabesignal einen Strom von dem Dekodiererschaltknoten (B) zu führen, wobei die Steuertransistoren in sämtlichen Dekodiererstufen an den Dekodiererschaltknoten angeschlossen sind, so daß als Antwort auf das Dekodiererfreigabesignal Strom über die Steuertransistoren und die Dekodiererschalteinrichtungen fließt;
B. der Ausgangskodiererabschnitt (14) eine Vielzahl von Kodiererstufen (60A-60M) enthält, die jeweils an einen Knoten (E) angeschlossen sind, der mit einer der Ausgangsleitungen verbunden ist, wobei mindestens einige der Stufen mindestens einen Steuertransistor (62A-62K) enthalten , der an den jeweiligen Knoten angeschlossen ist, um als Antwort auf die Auswahl der Zwischenleitung die Übertragung eines Ausgangssignales auf der Ausgangsleitung zu steuern, und eine Kodiererschalteinrichtung (30), die angeschlossen ist, um als Antwort auf ein Kodiererfreigabesignal Strom von einem Kodiererschaltknoten (C) zu führen, wobei die Steuertransistoren in den Kodiererstufen an den Kodiererschaltknoten angeschlossen sind, so daß als Antwort auf das Kodiererfreigabesignal Strom über die Steuertransistoren und die Kodiererschalteinrichtung fließt; und
C. eine auf ein Vorladungssignal ansprechende Vorladungseinrichtung (26A, 26B), um die jeweiligen Knoten (D, B, C, E) vorzuladen;
D. und das programmierbare Logik-Array gekennzeichnet ist durch
i) eine selbstgetaktete Schaltung (18), die einen Vorladungsleiter (23A) mit einem Taktknoten (A), einem widerstandsbildenden Transistor (54) und einer Takteinrichtung (54, 33A-33I),
ii) bei der der widerstandsbildende Transistor (54) die Dekodiererschalteinrichtung (28) an die Vorladungsleitung (23A) anschließt, und die Vorladungsleitung den widerstandsbildenden Transistor (54) an die Kodiererschalteinrichtung (30) anschließt, um das Kodiererfreigabesignal an die Kodiererschalteinrichtung (30) zu liefern, und die Vorladungsleitung (23A) an die Vorladungseinrichtung (26A,26B) angeschlossen ist, um den Taktknoten (A) an eine ausgewählte Spannung anzuschließen, wenn die jeweiligen Knoten vorgeladen sind,
iii) der widerstandsbildende Transistor (54) vorgespannt ist, um einen wirksamen Widerstand aufzuweisen, der etwas größer ist als der wirksame Widerstand irgendeiner der Steuertransistoren (52), und
iv) bei der die Takteinrichtung (54, 33A-33I) an die Vorladungsleitung und den Dekodiererschaltknoten (B) gekoppelt ist und durch die Dekodiererschalteinrichtung (28) gesteuert wird, um die Spannung auf dem vorgeladenem Taktknoten (A) mit einer vorgegebenen Geschwindigkeit zu reduzieren, bestimmt durch die Zeit nach der die Dekodiererschalteinrichtung (28) das Dekodiererfreigabesignal (28) empfängt, bei der das Kodiererfreigabesignal an den Ausgangskodiererabschnitt (14) geliefert wird, wobei die Dekodiererschalteinrichtung (28) die selbstgetaktete Schaltung (18) und den Dekodiererabschnitt (12) steuert.

2. Programmierbares Logik-Array nach Anspruch 1, bei welchem die selbstgetaktete Schaltung (18) desweiteren einen zwischen den Taktknoten (A) und die Kodiererschalteinrichtung (30) gekoppelten Inverter (58) enthält, um, wenn die Spannung auf dem Überwachungsknoten sinkt, den Spannungspegel des Kodiererfreigabesignales zu erhöhen, und die Kodiererschalteinrichtung (30) einen Transistor mit einem Steueranschluß aufweist, um als Antwort auf das einen ausgewählten Schwellenpegel überschreitende Kodiererfreigabesignal den Stromfluß durch die Kodiererschalteinrichtung (30) und die Steuertransistoren (62A-62K) freizugeben.

3. Programmierbares Logik-Array nach Anspruch 2, weiter gekennzeichnet durch die Takteinrichtung (54, 33A-33I), die desweiteren enthält:
A) eine an den Taktknoten angeschlossene Widerstands-Kapazitäts-Schaltung (33A-33I), wobei die Widerstands-Kapazitäts-Schaltung einen Kapazitätswert aufweist, der in Relation zum maximalen Kapazitätswert der Steuertransistoren (62A-62K) in irgendeiner der Dekodiererstufen ausgewählt ist, und den widerstandsbildenden Transistor (54) enthält; und
B) bei der die Vorladungseinrichtung den Taktknoten (A) und die Widerstands-Kapazitäts-Schaltung (33A-33I) vor dem Aktivsein des Dekodiererfreigabesignales vorlädt und sich die Widerstands-Kapazitäts-Schaltung während des Aktivseins des Dekodiererfreigabesignales über den widerstandsbildenden Transistor entlädt, um ein aktiviertes Kodiererfreigabesignal vorzusehen, wenn die Widerstands-Kapazitäts-Schaltung auf einen ausgewählten Pegel entladen wurde.

4. Programmierbares Logik-Array nach Anspruch 3, bei welchem die Widerstands-Kapazitäts-Schaltung (33A-33I) eine Vielzahl kapazitätsbildenden Transistoren enthält und die Anzahl der kapazitätsbildenden Transistoren der maximalen Anzahl der die Auswahl der Zwischenleitungen steuernden Steuertransistoren (52A-52N) entspricht.

5. Programmierbares Logik-Array nach Anspruch 1, weiter gekennzeichnet durch eine an die Kodiererschalteinrichtung (30) angeschlossene Kodierertakteinrichtung (35A-35J, 64), um zu einer ausgewählten Zeit nach dem Aktivwerden des Kodiererfreigabesignales ein Ausgangsfreigabesignal zu erzeugen.

6. Programmierbares Logik-Array nach Anspruch 5, weiter dadurch gekennzeichnet, daß:
A) die Kodiererüberwachungseinrichtung (35A-35J, 64) eine an den Kodierertaktknoten angeschlossene Kodierer-Widerstands-Kapazitäts-Schaltung (35A-35J), wobei die Kodierer-Widerstands-Kapazitäts-Schaltung einen Kapazitätswert aufweist, der in Bezug zum maximalen Kapazitätswert der Steuertransistoren (62A-62K) in irgendeiner der Kodiererstufen ausgewählt ist, und eine Kodiererwiderstandseinrichtung (64) aufweist, die mit dem Kodierertaktknoten und dem Kodiererschaltknoten (C) verbunden ist; und
B) die Vorladungseinrichtung vor dem Aktivsein des Kodiererfreigabesignales den Kodierertaktknoten und die Kodierer-Widerstands-Kapazitäts-Schaltung (35A-35J, 64) vorlädt, und während des Aktivseins des Kodiererfreigabesignales entlädt sich die Kodierer-Widerstands-Kapazitäts-Schaltung über die Kodiererwiderstandseinrichtung (64) entlädt, um ein aktiviertes Ausgangsfreigabesignal zu liefern, wenn die Kodierer-Widerstands-Kapazitäts-Schaltung auf einen ausgewählten Pegel entladen wurde.

## Revendications

1. Matrice logique programmable (10) comprenant une section décodeur d'entrée (12) et une section codeur de sortie (14) reliées par une pluralité de conducteurs intermédiaires (16A à 16K), ladite section décodeur d'entrée sélectionnant un conducteur intermédiaire en réponse au codage d'une pluralité de signaux d'entrée, et la section codeur de sortie transmettant une pluralité de signaux de sortie, chacun sur un conducteur respectif de sortie (20A à 20M) et ayant un codage déterminé par le conducteur intermédiaire sélectionné,
A. ladite section décodeur (12) comprenant une pluralité d'étages de décodeur (50A à 50K), chacun connecté à un noeud (D) auquel un desdits conducteurs intermédiaires est connecté, au moins quelques uns desdits étages de décodeur comprenant au moins un transistor de commande (52A à 52N) connecté audit noeud respectif pour commander la sélection desdits conducteurs intermédiaires sous la commande d'un signal d'entrée, et un moyen commutateur de décodeur (28) connecté au courant de conduite en provenance d'un noeud de commutateur de décodeur (B) en réponse à un signal d'activation de décodeur, lesdits transistors de commande dans tous lesdits étages de décodeur étant connectés audit noeud de commutateur de décodeur de façon à ce que le courant s'écoule à travers lesdits transistors de commande et ledit moyen commutateur de décodeur en réponse audit signal d'activation de décodeur ;
B. ladite section codeur de sortie (14) comprenant une pluralité d'étages de codeur (60A à 60M), chacun connecté à un noeud (E) auquel un desdits conducteurs de sortie est connecté, au moins quelques uns desdits étages comprenant au moins un transistor de commande (62A à 62K) connecté audit noeud respectif pour commander la transmission d'un signal de sortie sur ledit conducteur de sortie en réponse à la sélection dudit conducteur intermédiaire, et un moyen commutateur de codeur (30) connecté au courant de conduite en provenance d'un noeud de commutateur de codeur (C) en réponse à un signal d'activation de codeur, lesdits transistors de commande dans lesdits étages de codeur étant connectés audit noeud de commutateur de codeur de façon à ce que le courant s'écoule à travers lesdits transistors de commande et ledit moyen commutateur de codeur en réponse audit signal d'activation de codeur ; et
C. un moyen de précharge (26A, 26B) sensible à un signal de précharge pour précharger les noeuds respectifs (D, B, C, E) ;
D. ladite matrice logique programmable caractérisée de plus par
i) un circuit d'auto-cadencement (18) comprenant un conducteur de précharge (23A) ayant un noeud de cadencement (A), un transistor (54) fournissant une résistance, et un moyen de cadencement (54, 33A à 33I),
ii) dans lequel ledit transistor (54) fournissant une résistance connecte ledit moyen commutateur de décodeur (28) audit conducteur de précharge (23A), ledit conducteur de précharge connecte ledit transistor (54) fournissant une résistance audit moyen commutateur de codeur (30) pour fournir ledit signal d'activation de codeur audit moyen commutateur de codeur (30), et ledit conducteur de précharge (23A) est connecté audit moyen de précharge (26A, 26B) pour précharger ledit noeud de cadencement (A) à une tension sélectionnée quand lesdits noeuds respectifs sont préchargés,
iii) ledit transistor (54) fournissant une résistance est polarisé pour avoir une résistance effective légèrement plus grande que la résistance effective d'un quelconque des transistors de commande (52), et
iv) dans lequel ledit moyen de cadencement (54, 33A à 33I) est relié audit conducteur de précharge et audit noeud de commutateur de décodeur (B) et est commandé par ledit moyen commutateur de décodeur (28) pour réduire la tension sur ledit noeud de cadencement préchargé (A) à une vitesse prédéterminée déterminant le temps après lequel ledit moyen commutateur de décodeur (28) reçoit ledit signal d'activation de décodeur auquel le signal d'activation de codeur est fourni à ladite section codeur de sortie (14), ce par quoi ledit moyen commutateur de décodeur (28) commande ledit circuit d'auto-cadencement (18) et ladite section décodeur (12).

2. Matrice logique programmable selon la revendication 1, dans laquelle ledit circuit d'auto-cadencement (18) comprend de plus un inverseur (58) relié entre ledit noeud de cadencement (A) et ledit moyen commutateur de codeur (30) pour obliger le niveau de tension du signal d'activation de codeur à augmenter comme la tension sur ledit noeud de cadencement décroît, et ledit moyen commutateur de codeur (30) comprend un transistor ayant une borne de commande pour activer le débit de courant à travers ledit moyen commutateur de codeur (30) et lesdits transistors de commande (62A à 62K) en réponse audit signal d'activation de codeur dépassant un niveau de seuil sélectionné.

3. Matrice logique programmable selon la revendication 2, caractérisée de plus par ledit moyen de cadencement (54, 33A à 33I) comprenant en outre :
A) un circuit résistance-capacité (33A à 33I) connecté audit noeud de cadencement (A), ledit circuit résistance-capacité ayant une valeur de capacité sélectionnée en fonction de la valeur de capacité maximale des transistors de commande (62A à 62K) dans l'un quelconque desdits étages de décodeur, et comprenant ledit transistor (54) fournissant une résistance ; et
B) dans laquelle ledit moyen de précharge précharge ledit noeud de cadencement (A) et ledit circuit résistance-capacité (33A à 33I) avant l'affirmation dudit signal d'activation de décodeur, et pendant l'affirmation dudit signal d'activation de décodeur, ledit circuit résistance-capacité se décharge à travers ledit transistor fournissant une résistance pour fournir un signal d'activation de codeur affirmé quand ledit circuit résistance-capacité s'est déchargé jusqu'à un niveau sélectionné.

4. Matrice logique programmable selon la revendication 3, dans laquelle ledit circuit résistance-capacité (33A à 33I) comprend une pluralité de transistors fournissant une capacité, le nombre desdits transistors fournissant une capacité correspondant au nombre maximal de transistors de commande (52A à 52N) commandant la sélection d'un conducteur intermédiaire.

5. Matrice logique programmable selon la revendication 1, caractérisée de plus par ledit moyen de cadencement de codeur (35A à 35J, 64) connecté audit moyen commutateur de codeur (30) pour produire un signal d'activation de sortie à un temps sélectionné après l'affirmation dudit signal d'activation de codeur.

6. Matrice logique programmable selon la revendication 5, caractérisée de plus par
A) ledit moyen de cadencement de codeur (35A à 35J, 64) comprenant un circuit résistance-capacité de codeur (35A à 35J) connecté à un noeud de cadencement de codeur, ledit circuit résistance-capacité de codeur ayant une valeur de capacité choisie sélectionnée en relation à la valeur de capacité maximale des transistors de commande (62A à 62K) dans un quelconque des étages de codeur, et un moyen de résistance de codeur (64) connecté audit noeud de cadencement de codeur et audit noeud de commutateur de codeur (C) ; et
B) ledit moyen de précharge préchargeant ledit noeud de cadencement de codeur et ledit circuit résistance-capacité de codeur (35A à 35J, 64) avant l'affirmation dudit signal d'activation de codeur, et pendant l'affirmation dudit signal d'activation de codeur, ledit circuit résistance-capacité de codeur se déchargeant à travers ledit moyen de résistance de codeur (64) pour fournir un signal d'activation de sortie affirmé si ledit circuit résistance-capacité de codeur s'est déchargé jusqu'à un niveau sélectionné.
